Europäisches Patentamt

**European Patent Office** (11) Numéro de publication: **0 104 982**

Office européen des brevets A1

(12) **DEMANDE DE BREVET EUROPEEN**

(21) Numéro de dépôt: 83401757.6

(22) Date de dépôt: 06.09.83

(51) Int. Cl.³: **G 06 F 1/00**
**H 05 K 5/00, H 01 R 23/68**

(30) Priorité: 17.09.82 FR 8215743

(43) Date de publication de la demande:
04.04.84 Bulletin 84/14

(84) Etats contractants désignés:
**DE GB IT**

(71) Demandeur: **THOMSON-BRANDT**
**173, Boulevard Haussmann**
**F-75379 Paris Cedex 08(FR)**

(72) Inventeur: **Roustide, Didier**
**THOMSON-CSF SCPi 173, bld. Haussmann**
**F-75379 Paris Cedex 08(FR)**

(74) Mandataire: **Grynwald, Albert et al,**
**THOMSON-CSF SCPi 173, Bld Haussmann**
**F-75379 Paris Cedex 08(FR)**

(54) **Lecteur-enregistreur et ordinateur, notamment micro-ordinateur, comportant un tel lecteur-enregistreur.**

(57) Lecteur-enregistreur de disques ou bandes magnétiques constituant une mémoire d'ordinateur.

Les faces inférieure (18) et supérieure (24) du boîtier présentent des connecteurs complémentaires (17, 22) à la verticale l'un de l'autre. Le connecteur inférieur (17) établit la liaison entre l'unité centrale et un lecteur-enregistreur identique (14) disposé au-dessus dudit lecteur-enregistreur (13), les signaux de liaison transitant par le connecteur inférieur (17).

FIG_1

EP 0 104 982 A1

1

## LECTEUR-ENREGISTREUR ET ORDINATEUR, NOTAMMENT MICRO-ORDINATEUR, COMPORTANT UN TEL LECTEUR-ENREGISTREUR.

L'invention est relative à un lecteur-enregistreur de disques magnétiques ou de bandes magnétiques, en particulier en cassettes, constituant un organe périphérique d'un ordinateur, notamment d'un micro-ordinateur.

On sait que les possibilités d'utilisation d'un ordinateur sont d'autant plus étendues que sa capacité de mémoire est plus importante. C'est pourquoi un micro-ordinateur comprend souvent un lecteur-enregistreur de disques magnétiques et/ou un lecteur enregistreur de bandes magnétiques en cassettes, les disques et les bandes constituant des mémoires.

Pour l'échange d'informations entre le lecteur-enregistreur et l'unité centrale du micro-ordinateur on prévoit habituellement un câble ou une nappe de fils électriques. Si le micro-ordinateur comprend plusieurs lecteurs-enregistreurs ceux-ci sont reliés entre eux et à l'unité centrale également par l'intermédiaire de câbles ou nappes. Mais de telles connexions sont peu pratiques et peu esthétiques.

L'invention remédie à cet inconvénient.

Elle est caractérisée en ce que chaque lecteur-enregistreur présente sur les faces inférieure et supérieure de son boîtier des connecteurs électriques complémentaires à la verticale l'un de l'autre, le connecteur inférieur étant destiné à relier l'unité centrale audit lecteur-enregistreur et le connecteur supérieur étant destiné à établir une liaison entre l'unité centrale et un lecteur-enregistreur identique disposé au-dessus dudit lecteur-enregistreur, les signaux de liaison transitant par le connecteur inférieur.

Ainsi pour un ensemble de lecteurs-enregistreurs il suffit de prévoir un seul câble de liaison entre l'unité centrale et cet ensemble.

2

De préférence les parois inférieure et supérieure du boîtier comprennent des moyens de positionnement complémentaires à la verticale les uns des autres. Dans ce cas l'installation de plusieurs lecteurs-enregistreurs selon une pile s'effectue de façon particulièrement simple, les moyens de positionnement complémentaires, qui fixent les boîtiers les uns aux autres, assurant automatiquement le positionnement des connecteurs électriques complémentaires.

Dans une réalisation la liaison électrique entre les connecteurs des faces inférieure et supérieure est constituée par des pistes conductrices sur une plaquette verticale de circuit imprimé. Un bord de la plaquette de circuit imprimé peut constituer un connecteur mâle en saillie de la face inférieure ou supérieure.

Il est particulièrement avantageux que les pistes de circuits imprimés soient identiques pour tous les lecteurs-enregistreurs et d'une configuration telle que, l'unité centrale ou un contrôleur raccordé à cette dernière comportant un nombre de sorties d'adressage (ou validation) égal au nombre de lecteurs-enregistreurs empilables, chaque sortie d'un rang déterminé soit connectée au lecteur-enregistreur du même rang dans la pile de tels lecteurs-enregistreurs afin que ce lecteur-enregistreur soit en liaison avec l'unité centrale ou le contrôleur. Par exemple la sortie de rang n°1 est connectée automatiquement, de par la configuration des pistes de circuits imprimés, au lecteur-enregistreur de rang 1 c'est-à-dire le plus bas dans la pile; la sortie n°2 est connectée automatiquement au lecteur-enregistreur de rang n°2 c'est-à-dire le second en partant du bas, etc....

Pour réaliser cette dernière disposition la configuration des pistes est par exemple la suivante : toutes les extrémités de pistes aboutissent à un même bord inférieur de la plaquette de circuits imprimés; la première piste, par exemple celle dont l'extrémité est la plus à gauche, est destinée à la connexion d'une sortie d'adressage avec le lecteur-enregistreur comportant ladite plaquette; la seconde piste, c'est-à-dire celle dont l'extrémité inférieure est de rang 2 (en partant de la gauche dans l'exemple), a son extrémité supérieure de rang 1; et de même chaque autre piste relie une extrémité inférieure de rang n (n ⟩ 2) à une extrémité supérieure de rang n - 1.

Avec cette configuration il n'est pas nécessaire de prévoir de programmation d'adressage des lecteurs-enregistreurs.

D'autres caractéristiques et avantages de l'invention apparaîtront avec la description de certains de ses modes de réalisation, celle-ci étant effectuée en se référant aux dessins ci-annexés sur lesquels :

- la figure 1 est une vue schématique d'ensemble, en perspective, de deux lecteurs-enregistreurs de disques magnétiques empilés au-dessus d'un contrôleur de disques,

- la figure 2 est une vue schématique en perspective d'un boîtier de lecteur-enregistreur de disques magnétiques,

- la figure 3 est une vue en coupe à plus grande échelle d'une portion des parties respectivement supérieure et inférieure de l'empilement de deux lecteurs-enregistreurs de disques,

- la figure 4 est une vue en coupe selon un plan vertical de deux circuits imprimés et d'un connecteur,

- la figure 5 est une vue selon la flèche F de la figure 4,

- la figure 6 est une vue d'un circuit imprimé et des parois inférieure et supérieure d'un boîtier de lecteur-enregistreur de disques magnétiques, et

- la figure 7 est une vue montrant les circuits imprimés de connexion et les connecteurs correspondants de deux lecteurs-enregistreurs de disques empilés au-dessus d'un contrôleur de disques.

Dans l'exemple les lecteurs-enregistreurs de disques ou "floppy" sont reliés à un micro-ordinateur (non représenté) ou "ordinateur domestique".

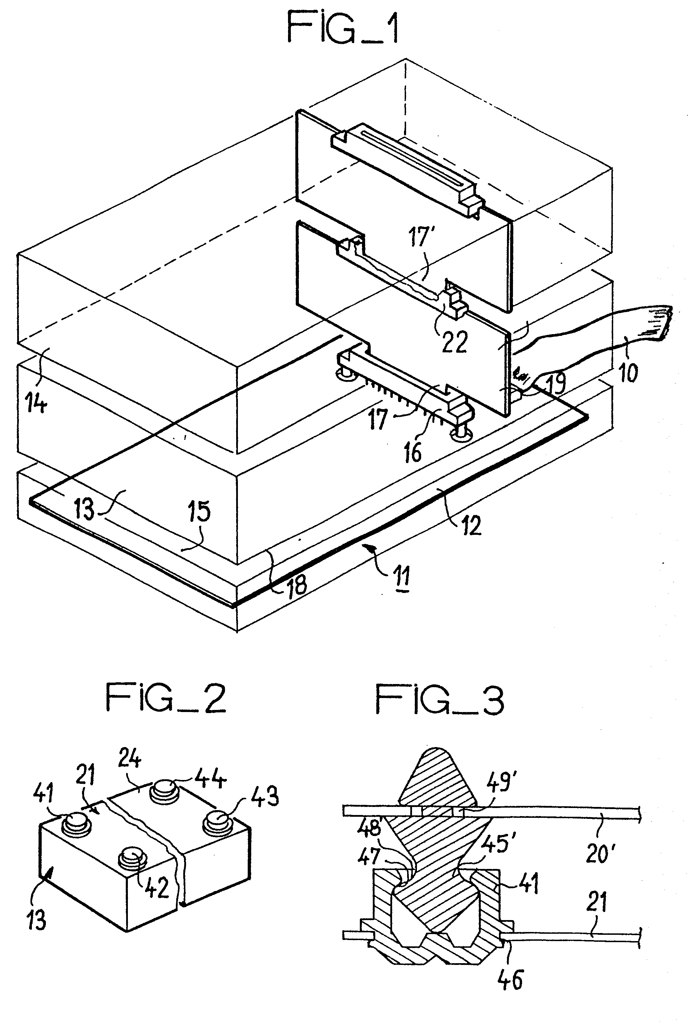

L'unité centrale du micro-ordinateur est connectée, par une nappe 10 de fils, à un contrôleur 11 de lecteurs-enregistreurs de disques qui comporte un circuit imprimé 12 (figure 1) et est de forme générale plate et rectangulaire. Ce contrôleur constitue un interface entre l'unité centrale et les lecteurs-enregistreurs de disques, respectivement 13 et 14.

Les lecteurs-enregistreurs 13 et 14 sont identiques entre eux à la fois en forme, en dimensions et en constitution. Ils ont, comme le contrôleur 11, un boîtier de forme générale plate et rectangulaire, les dimensions horizontales - longueur et largeur -du boîtier du contrôleur étant les mêmes que celles de chacun des lecteurs-enregistreurs 13, 14.

On n'a représenté sur les figures que les dispositions nécessaires à la compréhension de l'invention. En particulier les moyens mécaniques et électriques de lecture et d'enregistrement des disques n'ont pas été montrés, car ils sont de conception classique.

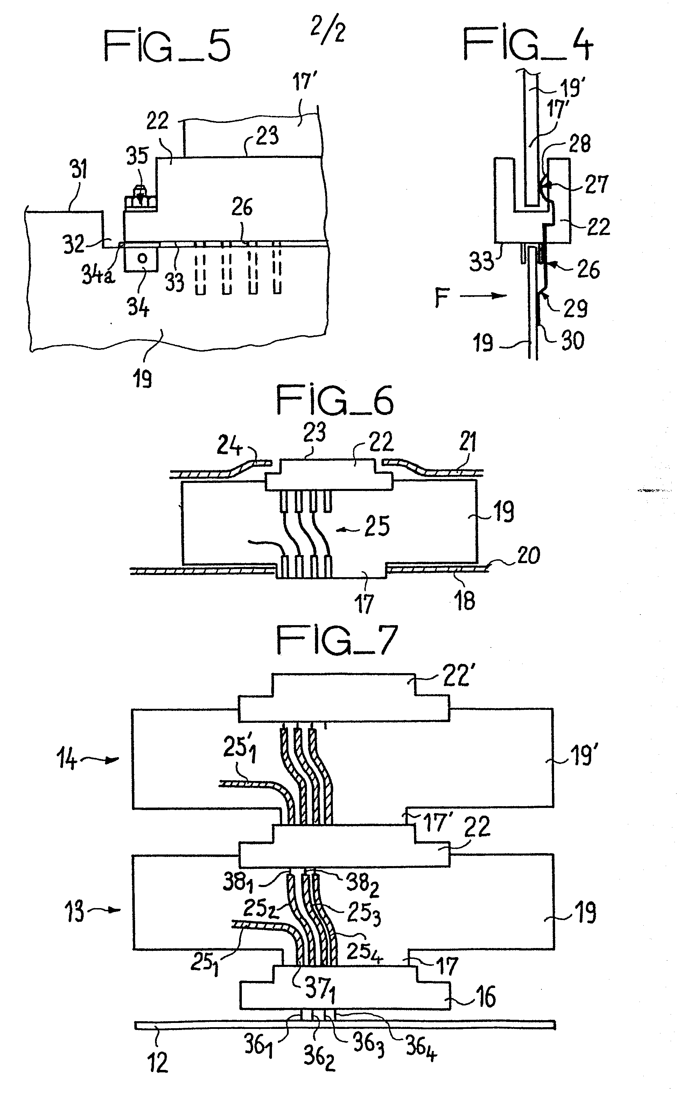

La face supérieure 15 du boîtier du contrôleur 11 présente un connecteur femelle 16, par exemple de type HE 902, destiné à coopérer avec un connecteur mâle 17 en saillie de la face inférieure 18 du boîtier du lecteur-enregistreur 13. Dans l'exemple le connecteur mâle 17 est une partie d'une plaquette 19 de circuit imprimé s'étendant (figure 6) entre les parois inférieure 20 et supérieure 21 du boîtier du lecteur-enregistreur 13. La largeur de cette plaquette 19 est pratiquement égale, dans cet exemple, à la largeur du boîtier du lecteur-enregistreur.

La partie supérieure de la plaquette 19 est solidaire d'un connecteur femelle 22, identique au connecteur 16, dont la tranche· supérieure 23 est légèrement au-dessus de la face supérieure 24 de la paroi supérieure 21 du boîtier du lecteur-enregistreur 13.

Le connecteur femelle 22 coopère avec le connecteur mâle 17' en saillie de la face inférieure du lecteur-enregistreur 14.

Pour la connexion électrique du connecteur femelle 22 aux pistes conductrices 25 de la plaquette 19 on prévoit des pattes 26 (figures 4 et 5) en nombre égal à celui des pistes 25. L'extrémité supérieure 27 de chaque patte 26 est fixée au boîtier de connecteur femelle 22 et comprend une partie cambrée 28 dans le logement d'introduction du connecteur mâle 17' du lecteur-enregistreur 14, chaque partie cambrée 28 étant destinée à entrer en contact avec une piste conductrice correspondante de ce connecteur mâle 17'.

La partie inférieure 29 de chaque patte 26 est cambrée sur une petite section de façon à présenter une partie extrême 30 parallèle au corps de la patte 26 en contact avec, et soudée à, une piste de la plaquette 19. Les pattes 26 sont par exemple du type à "wrapper", c'est-à-dire du genre de celles qui reçoivent des fils enroulés.

Pour la fixation (mécanique) du boîtier de connecteur 22 à la plaquette 19, le bord supérieur 31 de cette dernière présente une encoche 32 (figure 5) et, de la face inférieure 33 du boîtier de connecteur 22 est en saillie une patte 34 appliquée, grâce à une vis, contre la partie de plaquette 19 qui se trouve au fond de l'encoche 32. Cette patte 34 fait partie d'une pièce $34_a$ fixée au connecteur par un système à vis et écrou 35.

Dans l'exemple la paroi supérieure 21 du lecteur-enregistreur est bombée autour de l'ouverture du connecteur 22.

De la plaquette 12 de circuit imprimé du contrôleur 11 sont en saillie vers le haut des tiges conductrices $36_1$, $36_2$, etc.... (figure 7) qui sont räccordées électriquement aux contacts internes du connecteur femelle 16 (ces tiges peuvent également faire partie de ce connecteur). Les tiges $36_1$ à $36_4$ constituent les sorties du contrôleur 11 qui sont destinées à la sélection du lecteur-enregistreur qui sera en liaison avec le contrôleur par l'intermédiaire des autres tiges $36_5$ à $36_{19}$ (non montrées), qui constituent des entrées-sorties de ce contrôleur. Toutes les tiges 36 sont alignées, c'est-à-dire dans un même plan vertical.

Les bornes $36_5$ à $36_{19}$ fournissent, lorsqu'elles constituent des sorties, des signaux de commande de lecture ou d'écriture à l'un des lecteurs-enregistreurs. Réciproquement lorsque les bornes $36_5$ à $36_{19}$ constituent des entrées elles reçoivent, pour les transmettre à l'unité centrale, les signaux lus par un lecteur-enregistreur déterminé 13, 14, etc...

Les pistes 25 sur les plaquettes 19, 19'...de circuits imprimés sont telles que la borne $36_1$ est en liaison avec le lecteur-enregistreur 13, c'est-à-dire le premier, en partant du bas, des lecteurs-enregistreurs empilés; la borne $36_2$ est en liaison avec le second

6

lecteur-enregistreur 14; la borne $36_3$ est reliée au lecteur-enregistreur disposé au-dessus de celui de référence 14, et la borne $36_4$ est connectée au lecteur-enregistreur supérieur.

A cet effet la piste $25_1$, qui est de rang n°1 (en partant de la gauche) sur la plaquette 19, est reliée à la tige $36_1$ par l'intermédiaire du connecteur femelle 16 et du connecteur mâle 17 qui présente les extrémités inférieures 37 des pistes 25. La tige $36_2$ est connectée à la piste $25_2$, de rang n°2 sur la plaquette 19. De même la tige $36_3$ est connectée à la piste $25_3$ de rang n°3 sur la plaquette 19, et la tige $36_4$ est reliée à la piste $36_4$.

La piste $25_1$ est reliée à une porte de validation des divers circuits du lecteur-enregistreur 13. Lorsqu'elle reçoit un signal, les signaux provenant des bornes $36_5$ à $36_{19}$ agissent sur le lecteur-enregistreur 13. Autrement dit ce n'est que lorsque la piste $25_1$ véhicule un signal que le lecteur-enregistreur 13 peut fonctionner.

La piste $25_2$ est reliée à la première borne (en partant de la gauche) $38_1$ du connecteur 22. La piste $25_3$ est reliée à la seconde borne $38_2$ de ce même connecteur 22. De façon analogue la piste suivante $25_4$ est reliée à la borne de rang inférieur d'une unité du connecteur 22.

De cette manière lorsque le lecteur-enregistreur 14 est disposé au-dessus du lecteur-enregistreur 13, le connecteur 17' étant enfiché dans le connecteur femelle 22 du lecteur 13, la piste $25_2$ de la plaquette 19 est reliée à la piste $25'_1$ de la plaquette 19'. Ainsi la borne $36_2$ du contrôleur 11 est reliée à la piste $25'_1$ et une connexion est donc établie entre la borne $36_2$ et le second (en partant du bas) lecteur-enregistreur 14. On voit que, de façon plus générale, une connexion est établie entre la nième borne de commande du contrôleur 11 et le nième lecteur-enregistreur de la pile de tels appareils, et cela avec des appareils identiques en tous points, notamment en ce qui concerne les pistes 25, 25' sur les plaquettes de circuits imprimés 19, 19'.

Pour que les divers lecteurs-enregistreurs 13, 14, etc... soient convenablement empilés, tant pour des raisons esthétiques que pour

le bon fonctionnement (par coopération correcte des connecteurs femelles 22 avec les connecteurs mâles 17') chacun des boîtiers des lecteurs-enregistreurs comprend des moyens de positionnement par exemple du type de ceux représentés sur les figures 2 et 3.

A la paroi supérieure 21 du boîtier du lecteur-enregistreur 13 sont fixées, au voisinage des quatre coins, des coupelles 41, 42, 43 et 44 dont chacune est destinée à recevoir par encliquetage un pied correspondant 45' en saillie vers le bas de la paroi inférieure 20' du lecteur-enregistreur supérieur 14.

De même, la face supérieure du contrôleur 11 présente quatre coupelles destinées à recevoir les pieds du lecteur-enregistreur 13.

Chaque coupelle 41 est fixée par encliquetage à la paroi supérieure correspondante (figure 3). A cet effet la partie inférieure de chaque coupelle 41 présente une rainure périphérique 46 dans laquelle pénètre le bord d'une ouverture de la paroi 21. Pour permettre l'encliquetage d'un pied la partie supérieure de la face interne de la coupelle 41 comporte un redent 47 coopérant avec un épaulement 48' du pied 45'.

Le pied 45' est également fixé par encliquetage à la paroi 20' et comporte dans sa partie supérieure, à cet effet, une rainure 49' dans laquelle pénètre le bord d'une ouverture de cette paroi 20'.

Ainsi la mise en place des lecteurs-enregistreurs s'effectue de façon particulièrement simple et sûre et, en raison de la configuration des pistes $25_1$ à $25_4$ sur les plaquettes de circuits imprimés 19, 19', il n'est pas nécessaire de prévoir de programmation pour l'aiguillage des signaux vers les lecteurs-enregistreurs.

Il va de soi qu'un ordinateur, notamment un micro-ordinateur avec son unité centrale et ses organes périphériques constitués par le contrôleur et les lecteurs-enregistreurs, entre dans le cadre de l'invention.

Bien entendu à la place de lecteurs-enregistreurs de disques magnétiques on peut prévoir d'autres organes de lecture et/ou d'enregistrement empilables, par exemple des lecteurs-enregistreurs de bandes magnétiques, notamment en cassettes.

8

## REVENDICATIONS

1. Lecteur-enregistreur (13) de données, notamment lecteur-enregistreur de disques ou bandes magnétiques constituant une mémoire d'ordinateur, en particulier d'un micro-ordinateur, caractérisé en ce que les faces inférieure (18) et supérieure (24) de son boîtier présentent des connecteurs complémentaires (17, 22) à la verticale l'un de l'autre, le connecteur inférieur (17) étant destiné à relier l'unité centrale audit lecteur-enregistreur et le connecteur supérieur (22) étant destiné à établir une liaison entre l'unité centrale et un lecteur-enregistreur identique (14) disposé au-dessus dudit lecteur-enregistreur (13), les signaux de liaison transitant par le connecteur inférieur (17).

2. Lecteur-enregistreur selon a revendication 1, caractérisé en ce qu'il comporte une plaquette verticale de circuits imprimés (19) entre les connecteurs inférieur et supérieur.

3. Lecteur-enregistreur selon la revendication 2, caractérisé en ce que l'unité centrale (ou un contrôleur), à laquelle ledit lecteur-enregistreur (13) est destiné à être associé, en pile, avec d'autres lecteurs enregistreurs identiques (14), comportant N sorties d'adressage ($36_1$, $36_2$, $36_3$, $36_4$), la configuration des pistes (25) sur la plaquette (19) de circuits imprimés est telle que lorsqu'un signal apparaît sur la sortie de rang n une liaison est établie entre le lecteur-enregistreur de même rang n dans la pile et l'unité centrale ou le contrôleur.

4. Lecteur-enregistreur selon la revendication 3, caractérisé en ce que la plaquette de circuit imprimé (19) comprend N pistes d'adressage ($25_1$, $25_2$, $25_3$, $25_4$) dont la première ($25_1$) est destinée à établir la liaison entre un moyen d'autorisation de fonctionnement de ce lecteur-enregistreur (13) et une sortie d'adressage et dont les autres ($25_2$, $25_3$, $25_4$) établissent des liaisons entre le connecteur inférieur (17) et le connecteur supérieur (22).

5. Lecteur-enregistreur selon la revendication 4, caractérisé en ce que chaque piste d'adressage, à partir de celle de rang 2,

9

connecte une borne de même rang du connecteur inférieur (17) à la borne de rang inférieur d'une unité (38) du connecteur supérieur (22), les bornes de mêmes rangs ($37_1$, $38_1$) des connecteurs inférieur et supérieur étant à la verticale l'une de l'autre.

6. Lecteur-enregistreur selon l'une quelconque des revendications 2 à 5, caractérisé en ce qu'un bord - inférieur ou supérieur - de la plaquette verticale (19) de circuits imprimés constitue un connecteur mâle (17) formant l'un desdits connecteurs et l'autre bord - supérieur ou inférieur - est relié à un connecteur femelle (22) formant l'autre connecteur dudit lecteur-enregistreur.

7. Lecteur-enregistreur selon l'une quelconque des revendications précédentes, caractérisé en ce que les parois inférieure (20) et supérieure (21) comprennent des moyens de positionnement complémentaires (41 à 44, 45') à la verticale les uns des autres.

8. Lecteur-enregistreur selon la revendication 7, caractérisé en ce que la paroi inférieure (20) présente des pieds (45') et la paroi supérieure (21) des coupelles correspondantes (41 à 44).

9. Lecteur-enregistreur selon la revendication 8, caractérisé en ce que les pieds (45') et les coupelles (41) coopèrent par encliquetage.

10. Lecteur-enregistreur selon l'une quelconque des revendications 7 à 9, caractérisé en ce que les moyens de positionnement complémentaires sont fixés par encliquetage aux parois correspondantes, respectivement inférieure et supérieure.

11. Lecteur-enregistreur selon l'une quelconque des revendications 7 à 10, caractérisé en ce que le boîtier étant de forme générale rectangulaire les moyens de positionnement complémentaires sont au voisinage des quatre coins des faces supérieure et inférieure.

12. Ordinateur, notamment micro-ordinateur, comprenant une unité centrale et au moins un lecteur-enregistreur de disques ou bandes magnétiques, caractérisé en ce que ledit lecteur-enregistreur (13) est selon l'une quelconque des revendications précédentes.

10

13. Ordinateur selon la revendication 12, caractérisé en ce qu'il comporte entre l'unité centrale et le premier lecteur-enregistreur (13) un contrôleur (11) dont la face supérieure du boîtier comporte un connecteur (16) complémentaire du connecteur (17) de la paroi inférieure du premier lecteur-enregistreur (13).

14. Ordinateur selon la revendication 13, caractérisé en ce qu'il comprend un lecteur-enregistreur selon l'une quelconque des revendications 7 à 11 et en ce que la face supérieure du boîtier du contrôleur (11) présente des moyens de positionnement complémentaires des moyens de positionnement de la face inférieure du lecteur-enregistreur (13).

15. Ordinateur selon la revendication 13 ou 14, caractérisé en ce que le connecteur (16) du contrôleur (11) présente les entrées-sorties de l'ordinateur et les sorties d'adressage ($36_1$ à $36_4$).

0104982

1/2

FIG_1

FIG_2

FIG_3

FIG_5

FIG_4

31

22
35
23
17'

32
26

34a
33

34

19

19'
17'
28
27
22
33
26
F
29
19
30

FIG_6

24
23
22
21

25
19

17
18
20

FIG_7

22'

14
25'₁
19'

17'
22

13
38₁
38₂
25₃
25₂
19
25₁
25₄
17

37₁
16

12
36₁
36₂
36₃
36₄

**Office européen des brevets**

## RAPPORT DE RECHERCHE EUROPEENNE

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| Y | CH-A- 588 799 (VORS) <br> * Colonne 1, lignes 11-33, 43-45; colonne 2, lignes 5-8; figures 1-3 * | 1-3 | G 06 F 1/00 <br> H 05 K 5/00 <br> H 01 R 23/68 |
| | --- | | |
| Y | FR-A-2 478 883 (THOMSON-BRANDT) <br> * Page 1, lignes 5-22; page 3, lignes 2-28; figure 1 * | 1,6 | |
| | --- | | |
| Y | US-A-4 084 869 (INTEL) <br> * Colonne 2, lignes 40-48; colonne 3, lignes 17-47; colonne 4, lignes 1-7; figures 1-5 * | 1,6 | |
| | --- | | |
| A | DE-A-1 590 715 (BUNKER-RAMO) <br> * Page 3, lignes 17-19; page 4, lignes 3-12; figures 1-3 * | 7,11 | |
| | | | DOMAINES TECHNIQUES RECHERCHES (Int. Cl. ³) |
| A | COMPUTER DESIGN, vol. 21, no. 4, avril 1982, pages 103,104,106,107,109-111, Winchester, US <br> R. BRECHTLEIN: "An intelligent interface for disk/tape systems" <br> * Page 104, figure 1 * | 1 | G 06 F 1/00 <br> H 05 K 5/00 <br> H 01 R 23/68 <br> G 06 F 3/06 <br> G 06 F 13/40 <br> H 05 K 7/02 <br> H 05 K 3/36 |
| | ---     -/- | | |

Le présent rapport de recherche a été établi pour toutes les revendications

| Lieu de la recherche <br> LA HAYE | Date d'achèvement de la recherche <br> 19-12-1983 | Examinateur <br> DHEERE R.F.B.M. |
|---|---|---|

0104982

Numéro de la demande

**Office européen des brevets**

**RAPPORT DE RECHERCHE EUROPEENNE**

EP 83 40 1757

| DOCUMENTS CONSIDERES COMME PERTINENTS | | Page 2 |
|---|---|---|

| Catégorie | Citation du document avec indication, en cas de besoin, des parties pertinentes | Revendication concernée | CLASSEMENT DE LA DEMANDE (Int. Cl. ³) |
|---|---|---|---|
| A | ELECTRONIQUE ET APPL. INDUSTR., no. 271, juin 1979, pages 41-43, Paris, FR<br>J. DE MONTAIGNE: "Un contrôleur pour système de développement ou d'application à disques durs" *<br>Page 42, figure 2; page 43, deuxième colonne, troisième colonne, lignes 1-18 *<br><br>----- | 1 | |
| | | | DOMAINES TECHNIQUES RECHERCHES (Int. Cl. ³) |

Le présent rapport de recherche a été établi pour toutes les revendications

| Lieu de la recherche | Date d'achèvement de la recherche | Examinateur |
|---|---|---|
| LA HAYE | 19-12-1983 | DHEERE R.F.B.M. |